# FASCICULE DE BREVET EUROPEEN

(11) **EP 2 248 215 B1**
(45) Date de publication et mention de la délivrance du brevet: **12.08.2015**
(21) Numéro de dépôt: 08869114.2
(22) Date de dépôt: 18.12.2008
(51) Int. Cl.: H01M 8/12, H01M 4/86, H01M 4/88, H01M 4/90, C23C 14/08, C23C 14/34, C23C 14/35

(54) **PROCEDE DE FABRICATION D'UNE PILE A COMBUSTIBLE EN COUCHES MINCES A OXYDE SOLIDE DITE SOFC**
VERFAHREN ZUR HERSTELLUNG EINER SOGENANNTEN DÜNNSCHICHT-FESTOXIDBRENNSTOFFZELLE
METHOD FOR MAKING A SO-CALLED SOFC SOLID OXIDE THIN LAYER FUEL CELL

(30) Priorité: 20.12.2007 FR 0760124
(43) Date de publication de la demande: 10.11.2010
(73) Titulaire: Centre National de la Recherche Scientifique (CNRS), 75016 Paris (FR); Universite d'Orleans, 45000 Orléans (FR)
(72) Inventeur: BRAULT, Pascal, F-45560 Saint Denis En Val (FR)
(74) Mandataire: Regimbeau
(86) Numéro de dépôt international: PCT/EP2008/067863
(87) Numéro de publication internationale: WO 2009/083472

(56) Documents cités:
- EP-A- 1 750 317
- US-A- 5 395 704
- US-A- 6 007 683
- YOO ET AL: "Fabrication and characterization of thin film electrolytes deposited by RF magnetron sputtering for low temperature solid oxide fuel cells" JOURNAL OF POWER SOURCES, ELSEVIER, AMSTERDAM, NL, vol. 160, no. 1, 29 septembre 2006 (2006-09-29), pages 202-206, XP005649220 ISSN: 0378-7753

## Description

La présente invention concerne le domaine des piles à combustible en couches minces à oxyde solide dite SOFC selon l'acronyme anglo-saxon « Solid Oxid Fuel Cell » et plus particulièrement de leur procédé de fabrication.

Il est bien connu que les piles à combustible sont utilisées dans de nombreuses applications, et sont notamment considérées comme une alternative possible à l'utilisation d'énergies fossiles. En effet, ces piles permettent de convertir directement une source d'énergie chimique, par exemple de l'hydrogène, ou de l'éthanol, en énergie électrique.

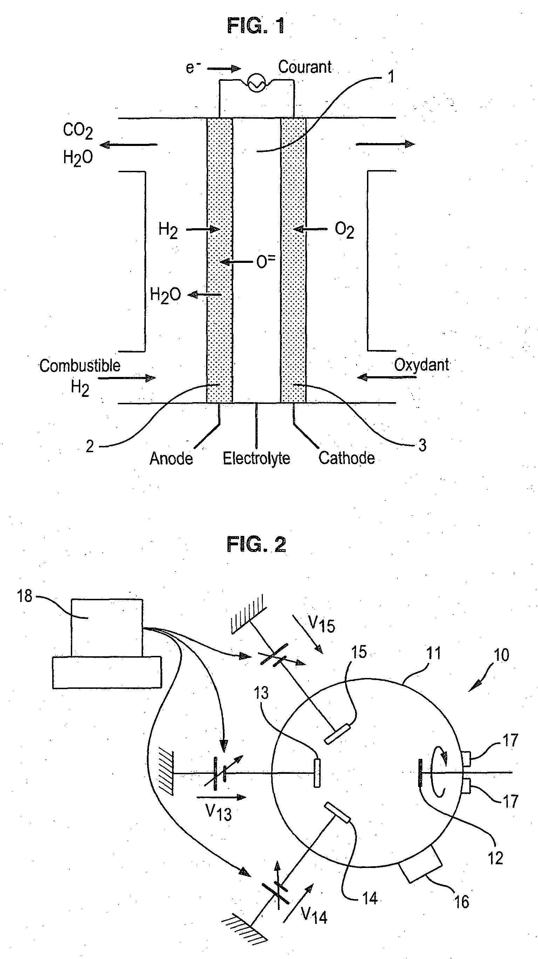

Une pile à combustible en couches minces du type SOFC est usuellement composée, en référence à la figure 1 qui est une représentation schématique d'une pile à combustible, d'un électrolyte 1 conducteur ionique, sur lequel sont déposées de part et d'autre une anode 2 et une cathode 3.

Le principe de fonctionnement d'une telle pile est le suivant : L'anode 2 est le siège de la réaction 2H₂+2O²⁻→ 2H₂O+4e⁻ l'électrolyte 1 étant responsable du transport de l'ion O²⁻ et la cathode 3 est le siège de la réaction suivante : O₂+4e⁻ → 2O²⁻ lorsque la pile est alimentée en hydrogène (H₂) et en oxygène (O₂).

L'anode 2 et la cathode 3 doivent être obtenues dans un matériau poreux afin d'assurer l'accessibilité des gaz et procurer l'évacuation de l'eau produite par la pile.

Par ailleurs, l'anode 2 et la cathode 3 doivent être électriquement conductrices pour assurer le transport du courant.

De plus, l'électrolyte 1 doit être obtenu dans un matériau dense et conducteur ionique pour procurer le transport de l'ion O²⁻.

Ainsi, ces piles à combustible sont usuellement constituées d'une anode 2 en Cermet Ni - ZrO₂-8%Y₂O₃, d'un électrolyte 1 en ZrO₂⁻ 8%Y2₃(YSZ) et d'une cathode 3 en LaSrMnO_{3-δ} (LSM).

Les procédés de fabrication usuels de ces piles à combustible SOFC sont la formation de couches successives formant l'anode 2, l'électrolyte 1 et la cathode 3 par coulage en bande, par sérigraphie, par dépôt par centrifugation, par projection plasma thermique ou par pulvérisation par flamme par exemple.

Toutefois, les piles à combustible obtenues selon ces procédés présentent des températures de fonctionnement trop élevées, comprises entre 700 et 1000°C, pour des applications dans les domaines des auxiliaires de puissances domestiques et des transports.

L'un des buts de l'invention est donc de remédier à ces inconvénients en proposant un procédé de fabrication de piles à combustibles présentant une température de fonctionnement basse, c'est-à-dire inférieure à 400°C.

Conformément à l'invention, il est proposé un procédé de fabrication conforme à la revendication 1.

L'anode (première électrode) et/ou la cathode (seconde électrode) comporte donc avantageusement au moins un catalyseur réparti dans ladite électrode. Ledit catalyseur est de préférence compris dans un élément ou une combinaison d'au moins deux éléments du groupe comprenant le groupe platine, les alliages platinoïdes tels que le platine-ruthénium, le platine-molybdène, le platine-étain, les métaux non platinoïdes tels que le fer, le nickel ou le cobalt.

Ledit groupe platine comporte le platine (Pt), le palladium (Pd), le ruthénium (Ru), le rhodium (Rh), l'osmium (Os) et l'iridium (Ir).

La première électrode, l'électrolyte et la seconde électrode sont successivement déposées dans une enceinte comportant au moins 3 cibles magnétron.

Les dépôts sont réalisés de préférence sous atmosphère oxydante.

Selon une caractéristique essentielle du procédé suivant l'invention, les dépôts sont effectués par un procédé de pulvérisation plasma magnétron réactif ionisé.

Ledit plasma est un plasma contenant au moins de l'oxygène et de préférence un mélange argon-oxygène.

Par ailleurs, la pression dans l'enceinte est variable.

La première électrode est obtenue par un dépôt par pulvérisation magnétron sur un substrat support.

Ledit substrat support consiste en un substrat apte à être dissout dans un liquide, ledit liquide ne dissolvant pas les électrodes et l'électrolyte de la pile à combustible.

Ladite première électrode formant l'anode de la pile à combustible est obtenue par pulvérisation magnétron d'une cible Ni-YSZ ou Srᵢ₋ₓYₓTiO3 sous atmosphère oxydante.

La polarisation de la cible et/ou la pression du gaz plasmagène et/ou la vitesse de rotation du substrat support est ajustée en continu au cours de la pulvérisation afin de faire varier la porosité dans la profondeur de la couche déposée formant la première électrode.

Selon une variante d'exécution, la première électrode formant l'anode ou la cathode constitue un substrat support obtenu dans un oxyde réducteur conducteur électronique ou conducteur ionique/électronique, et poreux sur lequel sont déposés l'électrolyte et la cathode ou respectivement l'anode.

Par ailleurs, l'électrolyte de la pile à combustible est obtenue par pulvérisation magnétron d'une cible de zircone yttriée ou de CeO₂ dopé avec du Sm203 ou Gd203 sous atmosphère oxydante.

La pulvérisation est obtenue par pulvérisation magnétron pulsée.

La seconde électrode formant la cathode de la pile à combustible est obtenue par pulvérisation magnétron d'une cible de LaxSr1-xMnO3 (LSM) de LaNiO_{4+δ} ou de NdₓNiO_{4+δ} sous atmosphère oxydante.

La polarisation de ladite cible et/ou la pression du gaz plasmagène et/ou la vitesse de rotation du substrat support est ajustée en continu au cours de la pulvérisation afin de faire varier la porosité dans la profondeur de la couche déposée formant la seconde électrode.

D'autres avantages et caractéristiques ressortiront mieux de la description qui va suivre, de plusieurs variantes d'exécution, données à titre d'exemples non limitatifs, du procédé de fabrication d'une pile à combustible du type SOFC conforme à l'invention, à partir des dessins annexés sur lesquels :
- la figure 1 est une représentation schématique d'une pile à combustible,
- la figure 2 est une représentation schématique d'une enceinte à vide d'un dispositif de dépôt par pulvérisation magnétron pour la mise en oeuvre du procédé suivant l'invention,

En référence à la figure 1, la pile à combustible est constituée d'un électrolyte 1 conductrice ionique, sur laquelle sont déposées de part et d'autre une électrode, plus précisément une anode 2 et une cathode 3.

L'électrolyte 1 est de préférence réalisée dans de la zircone yttriée (YSZ), et plus précisément dans de la zircone yttriée (YSZ) à 8%, présentant une haute densité afin d'optimiser la conduction des ions 02 dans la pile à combustible. Ladite densité devra être proche de 6,10 g/cm³.

Ladite électrolyte 1 pourra également être obtenue dans du CeO2 dopé avec du Sm203 ou Gd203 par exemple.

L'anode 2 est de préférence réalisée dans de la zircone yttriée Cermet Ni-YSZ dont la porosité est avantageusement variable dans la profondeur de la couche formant l'anode 2, la porosité moyenne étant de l'ordre de 50%.

Ladite anode 2 peut avantageusement comporter au moins un catalyseur réparti dans ladite anode 2. Ledit catalyseur consiste dans un élément ou une combinaison d'au moins deux éléments du groupe comprenant le groupe du platine, les alliages platinoïdes tels que le platine-molybdène, le platine-étain, et des métaux non platinoïdes tels que le fer (Fe), le nickel (Ni) ou le cobalt (Co).

Le groupe du platine inclut notamment le platine (Pt), le palladium (Pd), le ruthénium (Ru), le rhodium (Rh), l'osmium (Os) et l'iridium (Ir).

Accessoirement, la concentration en catalyseur augmente depuis la face extérieure vers la face intérieure de l'anode 2, c'est-à-dire depuis la face libre de l'anode 2 vers l'électrolyte1, afin d'améliorer l'efficacité d'utilisation dudit catalyseur.

On observera que l'anode 2 pourra également être obtenue par un dépôt de Sr₁₋ₓYₓTiO3 notamment.

La cathode 3 est réalisée en LaxSr1-xMnO3 (LSM) et comporte avantageusement un catalyseur tel que décrit précédemment pour l'anode 2. Par ailleurs, la porosité moyenne de la cathode 3 est également de l'ordre de 50%.

Accessoirement, et de la même manière que pour l'anode 2, la concentration en catalyseur augmente depuis la face extérieure vers la face intérieure de la cathode 3, c'est-à-dire depuis la face libre de la cathode 3 vers l'électrolyte1, afin d'améliorer l'efficacité d'utilisation dudit catalyseur.

De plus, ladite porosité pourra avantageusement être variable dans la profondeur de la couche formant la cathode 3.

On observera que la cathode 3 pourra également être obtenue par un dépôt de LaNiO_{4+δ} ou de NdₓNiO_{4+δ}.

Pour la fabrication de cette pile à combustible, en référence à la figure 2, on utilise un dispositif de pulvérisation plasma magnétron réactif éventuellement ionisé 10. Ce dispositif de pulvérisation magnétron 10 est constitué d'une enceinte sous vide 11, de forme générale cylindrique par exemple, dans laquelle s'étendent un porte-support 12 et au moins trois cibles magnétron 13,14 et 15.

Le porte support 12 est apte à être entraîné en rotation autour de la normale à la face principale de ce dernier de manière à permettre un dépôt uniforme des différents matériaux.

Les cibles magnétron 13,14 et 15 sont respectivement polarisées par des tensions variables V13, V14 et V15.

La première cible 13 est par exemple une cible de zircone yttriée (YSZ), et plus précisément dans de la zircone yttriée (YSZ) à 8%, pour la réalisation de l'électrolyte 1.

La seconde cible 14 est par exemple une cible de zircone yttriée Cermet Ni-YSZ pour la réalisation de l'anode 2 et la troisième cible 15 est une cible de LaxSr1-xMnO3 (LSM) pour la réalisation de la cathode 3.

Accessoirement, le dispositif comporte une quatrième cible, non représentée sur la figure 2, pour la pulvérisation d'un catalyseur simultanément à la pulvérisation du matériau de l'anode 2 et/ou de la cathode 3.

Le dispositif comporte, par ailleurs, une source d'émission de radiofréquence 16, tel qu'une antenne radiofréquence, afin de créer un plasma additionnel dans l'enceinte 11, de préférence un plasma contenant de l'oxygène tel qu'un plasma argon-oxygène par exemple, et de contrôler le taux d'oxydation des couches. Le flux d'oxygène pourra par exemple être compris entre 0 et 50% et le flux d'argon pourra être compris entre 1 et 50% par exemple.

Par ailleurs, le dispositif comporte un ou plusieurs aimants 17, des aimants permanents et/ou des électro-aimants, positionnés sous le porte support 12 et aptes à piéger lé plasma à basse pression à proximité du porte support 12. Il s'agit de préférence d'un plasma basse pression d'Argon, ou de tout autre gaz présentant une masse voisine de la masse de la cible. On entend par plasma basse pression, un plasma dont la pression est comprise entre 0,013 et 0,13 Pa (0,1 et 100 mTorr).

De plus, le dispositif peut avantageusement comporter un ordinateur 18 dans lequel un ou plusieurs chronogrammes sont enregistrés en mémoire et qui est apte à commander les tensions variables V13, V14 et V15 de manière à obtenir le profil souhaité.

Le procédé de fabrication consiste à placer un substrat support sur le porte support 12 du dispositif de pulvérisation plasma magnétron réactif éventuellement ionisé 10. Ledit substrat support pourra consister en un substrat apte à être dissout dans un liquide, ledit liquide ne dissolvant pas les électrodes 2,3 et l'électrolyte 1 de la pile à combustible.

L'anode 2 est réalisée par pulvérisation sur le substrat support de la cible 14 de Ni-YSZ sous atmosphère oxydante pour pouvoir contrôler le taux d'oxygène, avec ou sans l'assistance de la source d'émission de radiofréquence 16. L'anode 2 ainsi obtenue est en Cermet Ni-YSZ (zircone yttriée) dont la porosité pourra être variable dans la profondeur de la couche par ajustement continu des paramètres de polarisation de la cible 14 de pulvérisation magnétron et/ou de la pression du gaz plasmagène et/ou de la vitesse de rotation du porte support, lesdits paramètres de polarisation étant ajustés au moyen de la tension variable V14.

Selon une variante d'exécution du procédé suivant l'invention, le dépôt de la couche formant l'anode 2 est réalisé par pulvérisation magnétron réactive d'un alliage Ni-Y-Zr sous plasma de mélange argon-oxygène, avec ou sans l'assistance de la source d'émission de radiofréquence 16.

Par ailleurs, on observera que la variation de pression d'argon et/ou la variation de polarisation et/ou la variation de la vitesse de rotation du substrat support permet de contrôler la porosité de l'anode 2, la porosité moyenne étant usuellement voisine de 50%

On notera que l'Homme du métier pourra aisément ajuster la porosité, par des tests d'oxydation à cette anode 2, en fonction de l'application visée par la pile à combustible.

Pour un fonctionnement à basse température, c'est-à-dire à une température inférieure à 400°C, il est aisé d'incorporer un catalyseur dans la couche de Ni-YSZ formant l'anode 2 pendant le dépôt par co-pulvérisation ou en utilisant une cible additionnelle non représentée sur les figures.

Ledit catalyseur consiste dans un élément ou une combinaison d'au moins deux éléments du groupe comprenant le groupe du platine, les alliages platinoïdes tels que le platine-molybdène, le platine-étain, et des métaux non platinoïdes tels que le fer (Fe), le nickel (Ni) ou le cobalt (Co).

Le groupe du platine inclut notamment le platine (Pt), le palladium (Pd), le ruthénium (Ru), le rhodium (Rh), l'osmium (Os) et l'iridium (Ir).

Accessoirement, la co-pulvérisation pourra être réalisée de telle manière que la concentration en platine diminue vers l'intérieur de l'anode 2 pour diminuer sa quantité et améliorer son efficacité d'utilisation.

Après le dépôt de l'anode 2 sur le substrat support 2, on pulvérise la cible 13 de zircone yttriée sous atmosphère d'oxygène avec ou sans l'assistance de la source d'émission de radiofréquence, de préférence par pulvérisation magnétron pulsée afin de déposer une couche formant l'électrolyte 1 sur l'anode 2.

On observera que l'électrolyte 1 ainsi déposée doit présenter une grande densité, d'environ 6,10 g/cm³, pour optimiser la conduction des ions O²⁻ dans le réseau de l'électrolyte 1 de la pile à combustible.

De plus, cette technique de pulvérisation magnétron pulsée est particulièrement appropriée pour la pulvérisation de cibles isolantes en conservant les performances de dépôts de la pulvérisation continue.

Finalement, on dépose à partir de la cible 15 de LaₓSr₁-ₓMnO₃ (LSM) la cathode 3 sur l'électrolyte 1, ladite cible 15 étant pulvérisée sous atmosphère oxydante pour préserver la stoechiométrie en oxygène. Ladite cible 15 contient avantageusement un catalyseur pour un meilleur fonctionnement à basse température. De la même manière que précédemment, ledit catalyseur consiste dans un élément ou une combinaison d'au moins deux éléments du groupe comprenant le groupe du platine, les alliages platinoïdes tels que le platine-molybdène, le platine-étain, et des métaux non platinoïdes tels que le fer (Fe), le nickel (Ni) ou le cobalt (Co), le groupe du platine incluant notamment le platine (Pt), le palladium (Pd), le ruthénium (Ru), le rhodium (Rh), l'osmium (Os) et l'iridium (Ir).

On notera par ailleurs que la variation de pression d'argon et/ou la variation de polarisation et/ou la variation de la vitesse de rotation du substrat support permet de contrôler la porosité de la cathode 3, la porosité moyenne étant usuellement voisine de 50%.

L'ensemble anode 2, électrolyte 1 et cathode 3 est détaché du substrat support pat tout moyen approprié bien connu de l'homme du métier.

Selon une variante d'exécution du procédé de fabrication d'une pile à combustible suivant l'invention, l'électrolyte 1 puis la cathode 3 pourront être déposés sur un substrat support constitué d'un substrat formant l'anode 2, ledit substrat formant l'anode 2 étant obtenu dans un oxyde réducteur conducteur électronique ou conducteur ionique/électronique, tel que dans de la zircone yttriée Cermet Ni-YSZ ou Sr₁₋ₓYₓTiO3 par exemple, sans pour autant sortir du cadre de l'invention.

Selon une autre variante d'exécution du procédé de fabrication d'une pile à combustible suivant l'invention, l'électrolyte 1 puis l'anode 2 pourront être déposés sur un substrat support constitué d'un substrat formant la cathode 3, ledit substrat formant la cathode 3 étant obtenu dans un oxyde réducteur conducteur électronique ou conducteur ionique/électronique, tel que dans de la zircone yttriée Cermet Ni-YSZ ou Sr₁-ₓYₓTiO3 par exemple, sans pour autant sortir du cadre de l'invention.

Il est bien évident que l'électrolyte 1 pourra être obtenue par un dépôt par pulvérisation magnétron de CeO2 dopé avec du Sm203 ou Gd203 par exemple, que l'anode 2 pourra être obtenue par un dépôt par pulvérisation magnétron de Sr₁₋ₓYₓTiO3 et que la cathode 3 pourra être obtenue par un dépôt par pulvérisation magnétron de LaNiO_{4+δ} ou de NdₓNiO_{4+δ}, les cibles 13, 14 et 15 étant adaptées en conséquence.

Par ailleurs, il va de soi que l'électrolyte 1 pourra être obtenu dans tout oxyde conducteur ionique et que l'anode 2 et/ou la cathode 3 pourra être obtenu dans tout oxyde conducteur électronique et/ou dans tout oxyde conducteur mixte électronique/ionique, sans pour autant sortir du cadre de l'invention.

Enfin, il est bien évident que les exemples que l'on vient de donner ne sont que des illustrations particulières en aucun cas limitatives quant aux domaines d'application de l'invention.

## Revendications

1. Procédé de fabrication d'une pile à combustible en couches minces à oxyde solide comportant au moins une anode (2), un électrolyte (1) et une cathode (3) ledit procédé comportant au moins les étapes suivantes de
dépôt par pulvérisation magnétron de matériau d'anode sur un substrat support
pour former l'anode (2),
dépôt par pulvérisation magnétron d'un électrolyte (1) sur l'anode (2) et de
dépôt par pulvérisation magnétron de matériau de cathode sur l'électrolyte (1) pour former la cathode (3),
**caractérisé en ce que** au moins un catalyseur est incorporé dans l'anode (2) et/ou la cathode (3) simultanément à la pulvérisation du matériau de l'anode et/ou de la cathode, ledit catalyseur étant incorporé dans l'anode (2) et/ou la cathode (3) avec une concentration augmentant depuis une face extérieure libre de l'anode (2) ou de la cathode (3) vers une surface intérieure en contact avec l'électrolyte (1).

2. Procédé selon la revendication 1 dans lequel le catalyseur est compris dans un élément ou une combinaison d'au moins deux éléments du groupe comprenant :
- le groupe platine,
- les alliages platinoïdes tels que le platine-ruthénium, le platine-molybdène, le platine-étain,
- les métaux non platinoïdes tels que le fer, le nickel ou le cobalt.

3. Procédé selon la revendication 2 dans lequel le groupe platine comporte le platine (Pt), le palladium (Pd), le ruthénium (Ru), le rhodium (Rh), l'osmium (Os) et l'iridium (Ir).

4. Procédé selon l'une quelconque des revendications 1 à 3 dans lequel l'anode (2), l'électrolyte (1) et la cathode (3) sont successivement déposées dans une enceinte (10) comportant au moins 3 cibles magnétron (13, 14,15).

5. Procédé selon l'une quelconque des revendications 1 à 4 dans lequel les dépôts sont réalisés sous atmosphère oxydante.

6. Procédé selon l'une quelconque des revendications 1 à 5 dans lequel les dépôts sont effectués par un procédé de pulvérisation plasma magnétron réactif ionisé.

7. Procédé selon la revendication 6 dans lequel le plasma est un plasma contenant au moins de l'oxygène.

8. Procédé selon la revendication 7 dans lequel le plasma est un mélange argon-oxygène.

9. Procédé selon l'une quelconque des revendications 5 à 8 dans lequel la pression dans l'enceinte est variable.

10. Procédé selon la revendication 1 dans lequel le substrat support consiste en un substrat apte à être dissout dans un liquide, ledit liquide ne dissolvant pas les anode et cathode (2,3) et l'électrolyte (1) de la pile à combustible.

11. Procédé selon l'une quelconque des revendications 4 à 10 dans lequel l'anode (2) de la pile à combustible est obtenue par pulvérisation magnétron d'une cible (14) Ni-YSZ ou Sr₁₋ₓYₓTiO3 sous atmosphère oxydante.

12. Procédé selon la revendication 11 dans lequel la polarisation de la cible (14) et/ou la pression du gaz plasmagène et/ou la vitesse de rotation du substrat support est ajustée en continu au cours de la pulvérisation afin de faire varier la porosité dans la profondeur de la couche déposée.

13. Procédé selon l'une quelconque des revendications 1 à 9 dans lequel l'anode (2) ou la cathode (3) constitue un substrat support obtenu dans un oxyde réducteur conducteur électronique ou conducteur ionique/électronique, et poreux sur lequel sont déposés l'électrolyte (1) et la cathode (3) ou respectivement l'anode (2).

14. Procédé selon l'une quelconque des revendications 1 à 13 dans lequel l'électrolyte (1) de la pile à combustible est obtenue par pulvérisation magnétron d'une cible (13) de zircone yttriée (YSZ) ou de Ce02 dopé avec du Sm203 ou Gd203 sous atmosphère oxydante.

15. Procédé selon la revendication 14 dans lequel la pulvérisation est obtenue par pulvérisation magnétron puisée.

16. Procédé selon l'une quelconque des revendications 1 à 15 dans lequel la cathode (3) de la pile à combustible est obtenue par pulvérisation magnétron d'une cible (15) de LaxSr1-xMnO3 (LSM) de LaNiO_{4+δ} ou de NdₓNiO_{4+δ} sous atmosphère oxydante.

17. Procédé selon la revendication 16 dans lequel la polarisation de la cible (15) et/ou la pression du gaz plasmagène et/ou la vitesse de rotation du substrat support est ajustée en continu au cours de la pulvérisation afin de faire varier la porosité dans la profondeur de la couche déposée.

## Patentansprüche

1. Verfahren zur Herstellung einer Dünnschicht-Festoxidbrennstoffzelle, die mindestens eine Anode (2), einen Elektrolyt (1) und eine Kathode (3) umfasst, wobei das Verfahren mindestens die folgenden Schritte umfasst:
Abscheiden durch Magnetron-Zerstäubung von Anodenmaterial auf einem Trägersubstrat zum Bilden der Anode (2),
Abscheiden durch Magnetron-Zerstäubung eines Elektrolyten (1) auf der Anode (2) und
Abscheiden durch Magnetron-Zerstäubung von Kathodenmaterial auf dem Elektrolyten (1) zum Bilden der Kathode (3),
**dadurch gekennzeichnet, dass** gleichzeitig mit der Zerstäubung des Materials der Anode und/oder der Kathode mindestens ein Katalysator in der Anode (2) und/oder der Kathode (3) aufgenommen wird, wobei der Katalysator in der Anode (2) und/oder der Kathode (3) mit einer Konzentration eingebaut wird, die von einer freien Außenseite der Anode (2) oder der Kathode (3) in Richtung einer Innenfläche, die den Elektrolyt (1) berührt, zunimmt.

2. Verfahren nach Anspruch 1, wobei der Katalysator in einem Element oder einer Kombination von mindestens zwei Elementen der Gruppe enthalten ist, die Folgendes umfasst:
- die Platingruppe,
- Platinmetall-Legierungen, wie beispielsweise Platin-Ruthenium, Platin-Molybdän, Platin-Zinn,
- Nicht-Platinmetall-Legierungen, wie beispielsweise Eisen, Nickel oder Kobalt.

3. Verfahren nach Anspruch 2, wobei die Platingruppe Platin (Pt), Palladium (Pd), Ruthenium (Ru), Rhodium (Rh), Osmium (Os) und Iridium (Ir) umfasst.

4. Verfahren nach einem der Ansprüche 1 bis 3, wobei die Anode (2), der Elektrolyt (1) und die Kathode (3) nacheinander in einem Raum (10) abgeschieden werden, der mindestens 3 Magnetron-Ziele (13, 14, 15) umfasst.

5. Verfahren nach einem der Ansprüche 1 bis 4, wobei die Abscheidungen unter oxidierender Atmosphäre ausgeführt werden.

6. Verfahren nach einem der Ansprüche 1 bis 5, wobei die Abscheidungen durch ein ionisiertes reaktives Magnetron-Plasmazerstäubungsverfahren durchgeführt werden.

7. Verfahren nach Anspruch 6, wobei das Plasma ein Plasma ist, das mindestens Sauerstoff umfasst.

8. Verfahren nach Anspruch 7, wobei das Plasma ein Argon-Sauerstoff-Gemisch ist.

9. Verfahren nach einem der Ansprüche 5 bis 8, wobei der Druck in dem Raum variabel ist.

10. Verfahren nach Anspruch 1, wobei das Trägersubstrat aus einem Substrat besteht, das geeignet ist, in einer Flüssigkeit gelöst zu werden, wobei die Flüssigkeit nicht die Anode und Kathode (2, 3) und den Elektrolyten (1) der Brennstoffzelle löst.

11. Verfahren nach einem der Ansprüche 4 bis 10, wobei die Anode (2) der Brennstoffzelle durch Magnetron-Zerstäubung eines Ni-YSZ oder Sr₁₋ₓYₓTiO₃-Ziels (14) unter oxidierender Atmosphäre erhalten wird.

12. Verfahren nach Anspruch 11, wobei die Polarisation des Zieles (14) und/oder der Plasmagasdruck und/oder die Drehzahl des Trägersubstrats während der Zerstäubung kontinuierlich angepasst wird/werden, um eine variierende Porosität in der Tiefe der abgeschiedenen Schicht zu bewirken.

13. Verfahren nach einem der Ansprüche 1 bis 9, wobei die Anode (2) oder die Kathode (3) ein Trägersubstrat bildet, das in einem elektronisch leitfähigen reduzierenden oder ionisch/elektronisch leitfähigen und porösen Oxid erhalten wird, auf dem der Elektrolyt (1) und die Kathode (3) oder beziehungsweise die Anode (2) abgeschieden werden.

14. Verfahren nach einem der Ansprüche 1 bis 13, wobei der Elektrolyt (1) der Brennstoffzelle durch Magnetron-Zerstäubung eines Zieles (13) aus yttriertem Zirkon (YSZ) oder aus mit Sm₂O₃ oder Gd₂O₃ unter oxidierender Atmosphäre dotiertem CeO₂ erhalten wird.

15. Verfahren nach Anspruch 14, wobei die Zerstäubung durch gepulste Magnetron-Zerstäubung erhalten wird.

16. Verfahren nach einem der Ansprüche 1 bis 15, wobei die Kathode (3) der Brennstoffzelle durch Magnetron-Zerstäubung eines Zieles (15) aus LaₓSr₁₋ₓMnO₃ (LSM), aus LaNiO_{4+δ} oder aus NdₓNiO_{4+δ} unter oxidierender Atmosphäre erhalten wird.

17. Verfahren nach Anspruch 16, wobei die Polarisation des Zieles (15) und/oder der Plasmagasdruck und/oder die Drehzahl des Trägersubstrats während der Zerstäubung kontinuierlich angepasst wird/werden, um eine variierende Porosität in der Tiefe der abgeschiedenen Schicht zu bewirken.

## Claims

1. A method for making a thin layer solid oxide fuel cell including at least an anode (2), an electrolyte (1) and a cathode (3), said method including at least the following steps of
magnetron sputtering deposition of anode material on a supporting substrate forming the anode (2);
magnetron sputtering deposition of an electrolyte (1) on the anode (2) and
magnetron sputtering deposition of cathode material on the electrolyte forming the cathode (3),
**characterized in that** at least one catalyst is incorporated into the anode (2) et/or the cathode (3) simultaneously with the sputtering of the material of the anode (2) and/or of the cathode (3), said catalyst being incorporated into the anode (2) and/or the cathode (3) with a concentration that increases from a free outer face of the anode (2) or of the cathode (3) towards an inner face in contact with the electrolyte 1.

2. The method according to claim 1, wherein the catalyst is comprised in an element or a combination of at least two elements from the group comprising:
- the platinum group,
- platinoid alloys such as platinum-ruthenium, platinum-molybdenum, platinum-tin,
- non-platinoid metals such as iron, nickel or cobalt.

3. The method according to claim 2, wherein the platinum group includes platinum (Pt), palladium (Pd), ruthenium (Ru), rhodium (Rh), osmium (Os) and iridium (Ir) .

4. The method according to any one of claims 1 to 3, wherein the anode (2), the electrolyte (1) and the cathode (3) are successively deposited in a chamber (10) including at least 3 magnetron targets (13, 14, 15) .

5. The method according to any one of claims 1 to 4, wherein the depositions are carried out under an oxidizing atmosphere.

6. The method according to any one of claims 1 to 5, wherein the depositions are carried out with an ionized reactive magnetron plasma sputtering method.

7. The method according to claim 6, wherein the plasma is a plasma containing at least oxygen.

8. The method according to claim 7, wherein the plasma is an argon-oxygen mixture.

9. The method according to any one of claims 5 to 8, wherein the pressure in the chamber is variable.

10. The method according to claim 1, wherein the supporting substrate consists in a substrate capable of being dissolved in a liquid, said liquid not dissolving the anode and cathode (2, 3) and the electrolyte (1) of the fuel cell.

11. The method according to any one of claims 4 to 10, wherein the anode (2) of the fuel cell is obtained by magnetron sputtering of a Ni-YSZ or Sr₁₋ₓYₓTiO₃ target (14) under an oxidizing atmosphere.

12. The method according to claim 11, wherein the polarization of the target (14) and/or the pressure of the plasmagen gas and/or the speed of rotation of the supporting substrate is continuously adjusted during sputtering in order to vary the porosity in the depth of the deposited layer.

13. The method according to any one of claims 1 to 9, wherein the anode (2) or the cathode (3) forms a supporting substrate obtained in a porous electron-conducting or ion/electron-conducting reducing oxide, and on which the electrolyte (1) and the cathode (3) or respectively the anode (2) are deposited.

14. The method according to any one of claims 1 to 13, wherein the electrolyte (1) of the fuel cell is obtained by magnetron sputtering of a target (13) of yttriated zirconia (YSZ) or of CeO₂ doped with Sm₂O₃ or Gd₂O₃ under an oxidizing atmosphere.

15. The method according to claim 14, wherein sputtering is obtained by pulsed magnetron sputtering.

16. The method according to any one of claims 1 to 15, wherein the cathode (3) of the fuel cell is obtained by magnetron sputtering of a target (15) of LaₓSr₁₋ₓMnO₃ (LSM) of LaNiO_{4+δ} or NdₓNiO_{4+δ} under an oxidizing atmosphere.

17. The method according to claim 16, wherein the polarization of the target (15) and/or the pressure of the plasmagen gas and/or the speed of rotation of the supporting substrate, is continuously adjusted during sputtering in order to vary the porosity in the depth of the deposited layer.
